# EUROPÄISCHE PATENTSCHRIFT

(11) **EP 2 062 359 B1**
(45) Veröffentlichungstag und Bekanntmachung des Hinweises auf die Patenterteilung: **15.09.2010**
(21) Anmeldenummer: 07786407.2
(22) Anmeldetag: 28.07.2007
(51) Int. Cl.: H03K 17/955, E05F 15/00

(54) **EINKLEMMSCHUTZVORRICHTUNG**
ANTI-PINCHING DEVICE
DISPOSITIF DE PROTECTION ANTI-COINCEMENT

(30) Priorität: 30.08.2006 DE 202006013335 U
(43) Veröffentlichungstag der Anmeldung: 27.05.2009
(73) Patentinhaber: Brose Fahrzeugteile GmbH & Co. Kommanditgesellschaft Coburg, 96450 Coburg (DE)
(72) Erfinder: WÜRSTLEIN, Holger, 97475 Zeil am Main (DE); WEINGÄRTNER, Thomas, 96117 Memmelsdorf (DE); MÜLLER, Wolf-Christian, 69123 Heidelberg (DE)
(74) Vertreter: Tergau & Pohl Patentanwälte
(86) Internationale Anmeldenummer: PCT/EP2007/006697
(87) Internationale Veröffentlichungsnummer: WO 2008/025422

(56) Entgegenhaltungen:
- EP-A- 1 154 112
- EP-A- 1 277 907
- WO-A-2006/032357
- DE-A1- 4 006 119
- US-A1- 2003 085 679
- US-A1- 2006 117 862

## Beschreibung

Die Erfindung betrifft eine Einklemmschutzvorrichtung für ein schwenkbares Stellelement eines Kraftzeugs, umfassend einen kapazitiven Sensor zum berührungslosen Erkennen eines Hindernisses im Weg des Stellelements mit einer Elektrode zur Erzeugung eines äußeren elektrischen Feldes gegenüber einer Gegenelektrode, wobei die Elektrode sich in eine Radialrichtung der Schwenkbewegung des Stellelements erstreckt, und eine Steuereinheit, die dafür eingerichtet ist, eine Änderung einer zwischen der Elektrode und der Gegenelektrode ausgebildeten Messkapazität als einen Einklemmfall zu interpretieren, wenn die geänderte Messkapazität eine in Abhängigkeit von einem Öffnungswinkel des schwenkbaren Stellelements vorgegebene Auslöseschwelle überschreitet, und die Auslöseschwelle nachzuführen.

Bekannte Einklemmschutzvorrichtungen nutzen zum Erkennen eines Hindernisses insbesondere Sensoren, die auf dem kapazitiven Messprinzip aufgebaut sind. Dabei wird zwischen einer Elektrode und einer geeigneten Gegenelektrode ein elektrisches Feld aufgebaut. Tritt in dieses elektrische Feld ein Dielektrikum, d.h. ein Fremdkörper, ein, so verändert sich die Kapazität des von der Elektrode und der Gegenelektrode gebildeten Kondensators. Auf diese Weise kann theoretisch jedes Hindernis im Weg des Stellelements eines Kraftfahrzeugs detektiert werden, dessen relative Dielektrizitätszahl εᵣ sich von der relativen Dielektrizitätszahl von Luft unterscheidet. Das Hindernis im Weg des Stellelements wird ohne einen physischen Kontakt mit dem Sensor erkannt. Wird eine Kapazitätsänderung detektiert, so können rechtzeitig Gegenmaßnahmen, wie beispielsweise ein Stoppen oder ein Reversieren des Antriebs des Stellelements eingeleitet werden, bevor es zu einem tatsächlichen Einklemmen des Hindernisses kommt.

Berührungslos arbeitende, auf dem kapazitiven Messprinzip beruhende Einklemmsensoren sind beispielsweise aus der US 2006/0117862 A1, der EP 1 455 044 A2 und der EP 1 154 110 A2 bekannt. Diese Sensoren erzeugen mittels einer Elektrode und einer geeigneten Gegenelektrode ein äußeres elektrisches Feld, so dass ein in dieses äußere elektrische Feld eindringendes Dielektrikum als eine Kapazitätsänderung zwischen Elektrode und Gegenelektrode detektiert werden kann.

Bewegt sich beim Schließen des Stellelements die Elektrode des Sensors und die Karosserie oder ein Karosserieteil des Kraftfahrzeugs aufeinander zu, so erhöht sich die Kapazität des von Elektrode und Karosserie gebildeten Kondensators. Ist die Gegenelektrode des Sensors durch die Karosserie gebildet, muss der von der Position des Stellelements abhängige Kapazitätsverlauf berücksichtigt werden, um eine Fehlinterpretation als Einklemmfall zu vermeiden. Hierzu wird der Kapazitätsverlauf eines schwenkbaren Stellelements in der Regel über dem Öffnungswinkel des Stellelements gemessen und zur Kompensation abgespeichert. Für gleichartige Stellelemente kann dieser beispielsweise aus einer Versuchsanordnung ermittelte Verlauf auch fest in die Steuereinheit implementiert vorgegeben werden.

Zur Detektion eines Einklemmfalles wird in bekannten Einklemmschutzvorrichtungen, ausgehend von dem gemessenen Kapazitätsverlauf, eine vom Öffnungswinkel abhängige Auslöseschwelle vorgegeben, bei deren Überschreitung durch die aktuell gemessene Kapazität ein Einklemmfall interpretiert wird. Mechanische Toleranzen, temperaturbedingte Abstandsveränderungen oder Schmutzablagerungen führen jedoch zu einer Änderung des tatsächlichen Kapazitätsverlaufs über dem Öffnungswinkel. Damit eine derartige Änderung nicht zu einer unerwünschten Fehlinterpretation als ein Einklemmfall und somit zu einem störenden Stoppen oder zu einem Reversieren des Stellelements führt, ohne dass ein Hindernis im Stellweg wäre, ist es erforderlich, den Kapazitätsverlauf nach dem Ersteinbau und im Betrieb in bestimmten Zeitabständen zu ermitteln und die Auslöseschwelle entsprechend nachzuführen oder zu aktualisieren.

Nachteiligerweise weist die für einen Einklemmfall relevante Auslöseschwelle eines schwenkbaren Stellelements, wie beispielsweise einer elektrisch betätigbaren Heckklappe, einer elektrisch betätigbaren Motorhaube oder einer elektrisch betätigbaren Kraftzeugtür, während des gesamten Stellwegs eine relativ große Abhängigkeit vom Öffnungswinkel auf. Dies führt leicht zu Fehlinterpretationen und somit zu einem unerwünschten Stoppen oder Fehlreversieren des Stellelements. Insbesondere können kleine Veränderungen der Geometrie oder Verschmutzungen entlang der Schließkante zu einer nicht mehr tolerierbaren Änderung des Kapazitätsverlaufs führen, so dass ein häufiges Nachführen der Auslöseschwelle erforderlich ist.

Aufgabe der Erfindung ist es, eine Einklemmschutzvorrichtung der eingangs genannten Art für ein schwenkbaren Stellelement anzugeben, die sich durch eine möglichst hohe Detektionssicherheit auszeichnet. Ferner ist es Aufgabe der Erfindung, eine geeignete Auswerteschaltung für die Einklemmschutzvorrichtung anzugeben, mit der eine möglichst hohe Detektionssicherheit der Einklemmschutzvorrichtung ermöglicht ist.

Diese Aufgabe wird erfindungsgemäß dadurch gelöst, dass die entlang der Radialrichtung ausgerichtete Elektrode des Sensors in mehrere Segmente unterteilt ist, und dass die Steuereinheit dafür eingereichtet ist, die Auslöseschwelle segmentzugeordnet nachzuführen.

Die Erfindung basiert auf der Überlegung, dass die Detektionssicherheit der Einklemmschutzvorrichtung erhöht werden kann, indem eine hohe Ortsauflösung des Sensors in Radialrichtung gewährleistet wird. Dies wird durch die Unterteilung der Elektrode in mehrere Segmente erreicht, wobei die Kapazität jedes Segments einzeln messbar ist.

Dank der separaten Messung der Kapazität der einzelnen Segmente ist es möglich, für die unterschiedlichen Segmente jeweils einen zugeordneten Kapazitätsverlauf in Abhängigkeit des Öffnungswinkels zu bestimmen. Mit anderen Worten wird es durch die Erfindung ermöglicht, den für die Festsetzung einer Auslöseschwelle in Erfahrung zu bringenden Kapazitätsverlauf nicht nur als Funktion über dem Öffnungswinkel sondern auch als Funktion des radialen Abstands zur Drehachse der Schwenkbewegung zu ermitteln bzw. festzulegen. Hierdurch wird die räumliche Auflösung der Auslöseschwelle erhöht und somit insgesamt die Detektionssicherheit des Gesamtsystems verbessert. Beispielsweise beeinflusst eine mechanische Deformation eines radialaußenliegenden Teils des Stellelements nicht mehr die Kapazität eines radial innenliegenden Sensorsegments, so dass dessen Auslöseschwelle diesbezüglich nicht nachgeführt werden braucht. Auch können für unterschiedliche Segmente unterschiedliche Toleranzbereiche um die Auslöseschwellen vorgegeben werden. Dabei kann die Tatsache berücksichtigt werden, dass für ein radial außenliegendes Hindernis aufgrund der erhöhten Bahngeschwindigkeit bis zum Einklemmfall weniger Zeit gegeben ist als für ein radial innenliegendes Hindernis. Auch ermöglicht die radiale Auflösung der Auslöseschwelle, die hohe Abhängigkeit vom Öffnungswinkel zumindest für radial außenliegende Segmente zu eliminieren. Denn der Kapazitätsverlauf eines radial außenliegenden Segments zeigt im Unterschied zu dem eines radial innenliegenden Segments bei großen Öffnungswinkeln noch keine Abhängigkeit vom Öffnungswinkel. Denn bei einem radial außenliegenden Segment ist anfangs der Abstand zwischen der Sensorelektrode und der gegenüberliegenden Schließkante, die als Karosserieteil eine Gegenelektrode bildet, für eine Änderung der Messkapazität durch Annäherung noch vernachlässigbar klein.

Diese Erkenntnis wird zur Ansteuerung der Segmente der Elektrode ausgenutzt, indem die Auslöseschwellen oder Kapazitätsverläufe segmentzugeordnet sind und indem die Auslöseschwellen der Segmente separat nachgeführt werden. Die separate Nachführung der Auslöseschwellen der einzelnen Segmente ist mit einem vertretbaren technischen Aufwand realisierbar; insgesamt wird das Risiko eines Fehlreversierens deutlich minimiert.

In der Regel ist die durch einen in den Weg eines Stellelements eindringenden Fremdkörper verursachte Kapazitätsänderung klein. Eine solche Änderung der Kapazität kann jedoch um so besser detektiert werden, je kleiner die sich insgesamt zwischen Elektrode und Gegenelektrode ausbildende Kapazität ist. Die vorliegende Segmentierung der Elektrode bietet demnach den weiteren Vorteil, dass sich die Detektionsempfindlichkeit erhöht. Hierbei gilt, dass je höher die Anzahl der Segmente ist, desto höher wird die Detektionsempfindlichkeit sowohl der einzelnen Segmente als auch des Sensors.

Des weiteren erlaubt ein derart ausgestalteter kapazitiver Sensor grundsätzlich die Detektion einer Kapazitätsänderung mittels eines Multiplex-Verfahrens. Dabei können die einzelnen Segmente mittels separaten Zuleitungen entweder zeitlich versetzt (seriell) oder gleichzeitig (parallel) angesteuert werden. Die erste, serielle Besteuerung bietet den Vorteil, dass hierbei nur eine einzige Auswerteschaltung zur Kapazitätsänderung notwendig wird. Allerdings ist hierbei die Zeitkonstante zu beachten, bis alle Segmente nacheinander durchgeschaltet worden sind. Die zweite parallele Ansteuerung weist zwar die nachteilige Zeitverzögerung nicht auf, erfordert jedoch zur Auswertung mehrere Auswerteelektroniken, wodurch die Kosten erhöht werden.

Die Nachführung der segmentzugeordneten Auslöseschwellen kann während des Betriebs des Systems vorgenommen werden. Insbesondere kann die Auslöseschwelle automatisch nachgelernt werden. Die Auslöseschwelle kann insbesondere zur Kompensation der Alterung des Systems angepasst werden.

Gemäß einer bevorzugten Ausgestaltung ist die Steuereinheit dafür eingerichtet, die Auslöseschwelle der einzelnen Segmente in unterschiedlichen Zeitabständen nachzuführen. Hierzu kann eine Ansteuerung der einzelnen Segmente in Abhängigkeit von ihrem Messsignal erfolgen. Insbesondere wird die Auslöseschwelle von Segmenten, die eine große Kapazitätsvariation über dem Schließwinkel zeigen, in kurzen Zeitabständen nachgeführt, damit eine kleine Änderung des Kapazitätsverlaufs nicht fälschlicherweise als ein eingedrungenes Hindernis interpretiert wird. Entsprechend genügt es, die Auslöseschwelle von Segmenten, die eine geringe Variation der Kapazität über dem Öffnungswinkel aufweisen, weniger häufig nachzuführen.

Gemäß einer weiteren bevorzugten Ausgestaltung ist die Steuereinheit dafür eingerichtet, die Auslöseschwelle von radialinneren Segmenten in kürzeren Zeitabständen nachzuführen als die Auslöseschwelle von radialäußeren Segmenten. Hierbei wird die Erkenntnis umgesetzt, dass beim Schließen des schwenkbaren Stellelements die unterschiedlichen Bereiche des Stellelements in Radialrichtung, trotz des gleichen Öffnungswinkels, sich in einem unterschiedlichen Abstand zur gegenüberliegenden Schließkante befinden. Die radialinneren Bereiche des schwenkbaren Stellelements sind grundsätzlich näher an der gegenüberliegenden Schließkante als die radialäußeren. Somit unterliegen die radialinneren Segmente einer größeren Gefahr einer Änderung der Messkapazität, da stets die Geometrie oder die Beschaffenheit der gegenüberliegenden Schließkante Eingang in die Messkapazität findet. Die Messkapazität radial innenliegender Segmente ist stets vom Schließwinkel abhängig. Die Messkapazität radial außenliegender Segment hingegen zeigt insbesondere bei großen Schließwinkeln keine Abhängigkeit vom Schließwinkel mehr. Durch die häufigere Nachführung der Auslöseschwelle der radialinneren Segmente wird also der Gefahr eines Fehlreversierens während das Schließvorgangs effizient begegnet.

Bei sehr kleinen Öffnungswinkel, insbesondere im radialinneren Bereich der Elektrode, kann die Messkapazität des Kondensators so groß werden, dass eine Kapazitätsänderung aufgrund eines Hindernisses kaum mehr erfassbar ist. Um die Gefahr eines Fehlreversierens zu vermeiden und um die Steuereinheit zumindest teilweise zu entlasten, werden deshalb bevorzugt einzelne Segmente in Abhängigkeit vom Öffnungswinkel abgeschaltet. Insbesondere werden radialinnere Segmente früher, d.h. bei einem größeren Öffnungswinkel, abgeschaltet als radialäußere. Dabei ist die Gefahr einer Einklemmung im radialinneren Bereich eher als klein anzusehen, da ab einem gewissen geringen Öffnungswinkel gar kein Hindernis mehr in den eingeschränkten Stellweg eindringen kann. Um dennoch einen Einklemmfall detektieren zu können, kann ein Hindernis beispielweise mittels eines taktilen Sensors erkannt werden.

Die Nachführung der Auslöseschwelle kann grundsätzlich auf verschiedene Weisen erfolgen. Zum einen ist vorstellbar, dass die Steuereinheit den tatsächlichen Kapazitätsverlauf in regelmäßigen Abständen während eines Öffnungs- oder Schließvorgangs erfasst und den abgespeicherten Verlauf oder eine hieraus abgeleitete Auslöseschwelle entsprechend an den tatsächlichen Verlauf anpasst. Zweckmäßigerweise, da vergleichsweise kostengünstig, kann die Nachführung aber auch auf elektronischem Wege mittels geeigneter elektronischer Schaltmittel erfolgen. Mittels derartiger Schaltmittel wird erreicht, dass der Steuereinheit im Falle eines Einklemmfalles stets ein eindeutiges, insbesondere digitales Messsignal, und zwar unabhängig von einem tatsächlichen Kapazitätsverlauf, zugeleitet wird. Dies kann je nach Auswerteschaltung zur Erfassung der Messkapazität mit unterschiedlichen Mittel geschehen. Wird die Messkapazität beispielsweise mittels einer Brückenschaltung erfasst, so bietet es sich an, einen zweiten Brückenzweig gleicher Ausgestaltung parallel zu schalten und als Messsignal die Differenz der jeweils zwischen Widerstand und Kapazität abgegriffenen Spannungen, bzw. deren Amplituden oder gegenseitige Phasenlage, zu erfassen. Weicht die Messkapazität von der Referenzkapazität ab, so wird das Differenzsignal von Null verschieden, so dass sich ein Einklemmsignal leicht von einem Standardsignal beispielsweise mittels eines Komparators unterscheiden läßt und ein digitales Signal der Steuereinheit zugeführt wird. Zur Ausregelung der beiden Brückenzweige bietet es sich an, eine steuerbare Kapazität, insbesondere eine steuerbare Kapazitätsdiode, einzusetzen. Durch Regelung der Kapazitätsdiode mittels der Steuereinheit ist es möglich, eine geänderte Auslöseschwelle bzw. einen geänderten Kapazitätsverlauf nachzuregeln bzw. die Auslöseschwelle nachzuführen.

Um eine Fehldetektion eines Hindernisses zu vermeiden, wird die Auslöseschwelle bei einem Schließ- oder einem Öffnungsvorgang des Stellelements derart nachgeführt, dass die Differenz zwischen dem Signal der Messkapazität und dem der Referenzkapazität auch bei ansteigender Kapazitätsänderung beim Schließen des Stellelements die Auslöseschwelle nicht überschreitet. Mit anderen Worten wird die Referenzkapazität beim Schließ- oder Öffnungsvorgang entsprechend der Änderung der Messkapazität angesteuert. Alternativ kann die Nachführung der Auslöseschwelle softwarebasiert erfolgen, indem zu immer kleineren Öffnungswinkeln des Stellelements eine höhere Auslöseschwelle vorgegeben wird, so dass sie vom Differenzsignal, auch beim ständig wachsenden Unterschied zwischen Mess- und Referenzsignal, nicht überschritten wird.

Die abgegriffene Spannung der Mess- und der Referenzkapazität ist außerdem jeweils vom Widerstand in beiden Messzweigen abhängig. Eine Anpassung des gemessenen Spannungssignals der Referenzkapazität kann also nicht nur durch eine entsprechende Anpassung der Kapazität selbst, sondern auch durch eine Variierung des Widerstandes erfolgen. Hierbei ist die Steuereinheit vorzugsweise derart eingereichtet, zur Nachführung der Auslöseschwelle einen steuerbaren Vorwiderstand zu regeln. Für diesen Zweck ist zumindest auf dem Referenzzweig der Brückenschaltung ein veränderbarer Widerstand vorgesehen, der durch die Steuereinheit zur Anpassung der geänderten Messkapazität nachgeregelt wird.

Alternativ kann die Messkapazität mittels einer Schwingkreisresonanz oder einer Schwingkreisverstimmung erfasst werden. Hierbei ist die Steuereinrichtung vorteilhafterweise dafür eingerichtet, zur Nachführung der Auslöseschwelle eine Resonanzfrequenz anzupassen, da nunmehr aufgrund der geänderten Kapazität eine geänderte Resonanzfrequenz einem Einklemmfall entspricht.

Nach einer bevorzugten Ausgestaltung ist die Steuereinheit dafür eingerichtet, die Auslöseschwelle als einen Abstandwert zu dem Kapazitätsverlauf der Messkapazität in Abhängigkeit von dem Öffnungswinkel vorzugeben. Die Auslöseschwelle stellt somit einen Grenzwert eines Toleranzbereichs über dem Kapazitätsverlauf dar, in welchem Toleranzbereich eine Kapazitätsänderung nicht als Hindernis übersetzt wird. Hierbei ist die Auslöseschwelle funktional vom Kapazitätsverlauf abhängig, und ihre Nachführung erfolgt mittelbar über dem Kapazitätsverlauf jedes Segments des Sensors.

Nach einer weiteren bevorzugten Ausgestaltung, ist die Steuereinheit dafür eingerichtet, den Abstandswert nachzuführen. Hierbei wird der Abstandswert direkt in Abhängigkeit vom Öffnungswinkel angepasst, ohne dass er als Funktion des Kapazitätsverlaufs dargestellt werden muss. Dies bedeutet, dass nachdem der Kapazitätsverlauf in Abhängigkeit vom Öffnungswinkel jedes einzelnen Segments einmal bekannt ist, ein winkelabhängiger Verlauf des Abstandswerts bestimmt wird, der z.B. in Form einer mathematischen Korrelation oder einer Look-Up Tabelle gespeichert wird. Dieser Verlauf kann dann den tatsächlichen Bedingungen nachgeführt werden. Insbesondere kann der Abstandswert segmentzugeordnet verschieden sein, um somit unterschiedlich empfindliche Sensorbereich zu schaffen. Selbstverständlich kann auch der Kapazitätsverlauf oder die Auslöseschwelle selbst als Funktion über dem Öffnungswinkel in Form einer mathematischen Korrelation oder in Form einer Look-Up Table gespeichert sein, wobei zur Nachführung die Korrelation oder die Look-Up Table geändert wird.

Vorteilhafterweise ist die Elektrode in einem flexiblen Träger geführt. Ein derartiger Träger erlaubt eine Anpassung des Sensors an die gegebenen Konturen eines Kraftfahrzeugs. Insbesondere kann der Sensor insgesamt als ein flexibles Flachbandkabel ausgeformt sein. Auch ist es vorstellbar, den Sensor als einen Dichtkörper auszugestalten oder den Sensor in einen Dichtkörper zu integrieren. Der Dichtkörper ist dabei vorgesehen, um das Stellelement gegenüber der Schließkante in einem geschlossenen Zustand abzudichten.

Ein flexibles Flachbandkabel wird auch als FFC ("Flexible Flat Cable") bezeichnet, und zeichnet sich dadurch aus, dass in einem flexiblen Kabelkörper parallele Leiterstrukturen verlegt sind. Alternativ zu einem FFC kann auch eine flexible Leiterstruktur verwendet werden. Eine flexible Leiterstruktur ist auch unter dem Begriff FPC ("Flexible Printec Circuit") bekannt. Dabei sind in einem flexiblen Isoliermaterial, insbesondere in mehrschichtiger Anordnung, Leiterbahnen spezifisch angeordnet oder verlegt. Eine solche Ausgestaltung erlaubt eine hohe Flexibilität hinsichtlich der Dimensionierung und Anordnung der einzelnen Leiterbahnen.

Weiter von Vorteil ist es, wenn im flexiblen Träger zusätzlich eine Abschirmelektrode zur Richtung des elektrischen Feldes in einen Gefährdungsbereich vorgesehen ist. Die Elektrode und die Abschirmelektrode sind im Wesentlichen gegenüber angeordnet und voneinander isoliert. Dabei befindet sich die Abschirmelektrode auf demselben Potential wie die Elektrode. Wird eine solche Abschirmelektrode zwischen Elektrode und Gegenelektrode eingeführt, so wird das sich zwischen Elektrode und Abschirmelektrode ausbildende elektrische Feld und somit eine direkte Kapazität deutlich verringert. Nach Art eines Streufeldkondensators bildet sich durch diese Ausgestaltung zwischen der Elektrode und der Gegenelektrode ein elektrisches Feld aus, das weit in den Raum hinein gerichtet ist. Hierdurch wird der Detektionsraum bzw. die Reichweite des Sensors deutlich erhöht.

Zweckmäßigerweise ist auch die Abschirmelektrode in elektrisch kontaktierte Abschirmsegmente unterteilt, zwischen denen isoliert separate Zuleitungen angeordnet sind. Hierdurch wird sicher vermieden, dass zwischen den Zuleitungen und der Gegenelektrode eine Kapazität ausgebildet wird. Jede Zuleitung wird auf diese Weise gegenüber der Gegenelektrode abgeschirmt.

Nach einer bevorzugten Variante umfasst die Einklemmschutzvorrichtung zusätzlich einen taktilen Sensor. Der taktile Sensor ist als eine Art Back-up-Sensor vorgesehen, der ein Hindernis auch bei einer Störfunktion oder bei abgeschalteten Segmenten des berührungslosen Sensors detektieren soll. Der taktile Sensor kann auch auf einem kapazitiven Messprinzip aufbauen. Hierbei zeigt er bei einer Berührung beispielweise aufgrund einer durch die Berührung hervorgerufenen Kraft- bzw. Druckwirkung eine Kapazitätsänderung, die von der Steuereinheit detektiert und ausgewertet wird. Der taktile Sensor ist insbesondere ebenfalls wie der berührungslose Sensor in unterschiedliche Segmente bzw. Segmentgruppen unterteilt.

Nach einer weiteren bevorzugten Variante, die sich durch einen geringen Platzbedarf auszeichnet, ist der berührungslose Sensor zugleich als taktiler Sensor ausgestaltet. Ein solcher kombinierter berührungsloser und taktiler Sensor kann geschaffen werden, indem zusätzlich zu der Elektrode, der Gegenelektrode und der Abschirmelektrode eine Grundelektrode sowie eine Innenelektrode vorgesehen sind, wobei die Abschirmelektrode und die Innenelektrode durch die Grundelektrode, welche mit dem Grundpotential verbunden ist, voneinander getrennt sind. Wenigstens die Grundelektrode und die Innenelektrode sind in ein elektrisch isolierendes, elastisches Material eingebettet. Die Einheit, umfassend die Grundelektrode, die Innenelektrode und das zwischen den Elektroden angeordnete elastische Material bildet einen taktilen kapazitiven Sensor. Hierbei wird zur taktilen Detektion eines Hindernisses die zwischen der Innenelektrode und der Grundelektrode gebildete Kapazität herangezogen. Wenn eine Krafteinwirkung auf den Sensor durch ein externes Hindernis erfolgt, wird das elastische Material komprimiert und seine Dicke verändert sich. Somit verändert sich der Abstand zwischen der Innenelektrode und der Grundelektrode, was zu einer detektierbaren Kapazitätsänderung des taktilen kapazitiven Sensors führt. Somit wird eine Berührung des Sensors durch das Hindernis detektiert.

Fällt die berührungslose Detektion aus, so erfolgt das Erkennen eines Hindernisses immer noch infolge der Detektion der mechanischen Einwirkung auf den Sensor, wodurch sich die zwischen der Innen- und der Grundelektrode gebildete Kapazität verändert.

Der Sensor kann in einfacher Art und Weise zum Erkennen eines Hindernisses im Weg eines Stellelements eines Kraftfahrzeugs eingesetzt werden, wenn als Gegenelektrode die geerdete Karosserie des Kraftfahrzeugs dient. Hierzu wird der beschriebene Sensor derart entlang von Konturen des Kraftfahrzeugs geführt, dass die Abschirmelektrode zwischen der Karosserie und der Elektrode zum Liegen kommt. Die Auswerteschaltung detektiert hierbei die sich zwischen der Elektrode und der geerdeten Karosserie gebildete Kapazität. Der Sensor ist bevorzugt an einem beweglichen Teil des Stellelements angeordnet, beispielsweise an einer Heckklappe des Kraftfahrzeugs, er kann aber auch an einem der Heckklappe gegenüberliegenden Bereich der Karosserie angeordnet sein.

Die zweitgenannte Aufgabe wird erfindungsgemäß durch eine Auswerteschaltung gelöst, die Messpotenzialausgabemittel zur Ausgabe eines vorgegebenen Messpotenzials an die Elektrode, Kapazitätserfassungsmittel zur Erfassung der Messkapazität zwischen der Elektrode und der Gegenelektrode und Auswertemittel für Ausgabe eines Detektionssignals in Abhängigkeit von einer Änderung der Messkapazität umfasst.

Die Messpotenzialausgabemittel dienen zur Erzeugung eines zur Erfassung der Messkapazitäten erforderlichen Messpotenzials, welches an der Elektroden anliegt. Hierzu können die Messpotenzialausgabemittel beispielsweise einen Gleichspannungs- oder einen Wechselspannungsgenerator umfassen. So kann über einen Gleichspannungsgenerator eine Messkapazität beispielsweise mittels einer Ladezeitauswertung erfasst werden. Ein Wechselspannungsgenerator ermöglicht eine Erfassung der Messkapazitäten über Ihren komplexen Widerstand oder Wechselstromwiderstand mittels eines Spannungsteilers. Auch ermöglicht ein steuerbarer Wechselspannungsgenerator die Erfassung der Messkapazitäten über eine Phasenverstimmung. Die Messpotenzialausgabemittel können auch ausgebildet sein, um die Messkapazitäten über eine Schwing- oder Resonanzkreisverstimmung erfassen zu können.

Die Kapazitätserfassungsmittel können durch elektronische Bauelemente realisiert sein. Insbesondere können aber auch Signale digitalisiert und mittels eines Rechners miteinander verglichen, einer Logik-Operation unterzogen oder in einer sonstigen Art und Weise verarbeitet werden, um als Messsignal eine Änderung des Abstands oder der Differenz der Messkapazitäten zueinander feststellen zu können.

Die Auswertemittel sind ausgestaltet, um aus dem erfassten Messsignal auf einen Einklemmfall zu schließen und in einem solchen Fall ein entsprechendes Detektionssignal zu erzeugen. Auch die Auswertemittel können mittels elektronischer Bauteile oder durch eine geeignete Software und einem entsprechenden Rechner verwirklicht sein. Vorzugsweise umfassen die Messpotenzialausgabemittel eine Wechselspannungsquelle und die Kapazitätserfassungsmittel umfassen eine Brückenschaltung, wobei die Messkapazität in dem Brückenzweig mit einer steuerbaren Kapazitätsdiode parallel geschaltet ist. Mittels der Messpotenzialausgabemittel wird eine Wechselspannung gewünschter Höhe und Frequenz zwischen die Elektrode und die Gegenelektrode angelegt. Die Differenz der Messkapazitäten kann dann beispielsweise durch Erfassung der entsprechenden Wechselspannungswiderstände gebildet werden. Zudem umfassen die Kapazitätserfassungsmittel jeweils eine Brückenschaltung, wobei die Messkapazitäten in den Brückenzweigen parallel geschaltet sind. Somit kann ein Differenzsignal, welches der Differenz der Messkapazitäten entspricht, in schaltungstechnisch vergleichsweise einfacher Art und Weise durch Abgriff der an den Messkapazitäten abfallenden Spannungen oder durch einen Phasen- oder Amplitudenunterschied der Spannungen in den beiden Brückenzweigen ermittelt werden. Hierbei bietet sich ein Differenzverstärker an, der die Differenz der an den Kapazitäten abfallenden Spannungen bildet. Hierzu kann dem Differenzverstärker beispielsweise eine Spitzenwerterkennung vorgeschaltet sein.

Ausführungsbeispiele der Erfindung werden anhand einer Zeichnung näher erläutert. Dabei zeigen:
- Fig. 1: schematisch eine Seitenansicht eines Kraftfahrzeugs,
- Fig. 2: in einer stark vereinfachten Darstellung eine Seitensicht auf eine Heck- klappe eines Kraftfahrzeugs,
- Fig. 3: in einem Diagramm einen beispielhaften Kapazitätsverlauf und einen Verlauf einer Auslöseschwelle als Funktion eines Öffnungswinkels,
- Fig. 4: eine Spannungsteilerschaltung zur Erfassung einer Messkapazität,
- Fig. 5: eine weitere Brückenschaltung zur Erfassung einer Messkapazität,
- Fig. 6: in einer Aufsicht einen durch eine flexible Leiterstruktur realisierten Sen- sor, und
- Fig. 7: in einem Querschnitt einen kombinierten berührungslosen und taktilen kapazitiven Sensor.

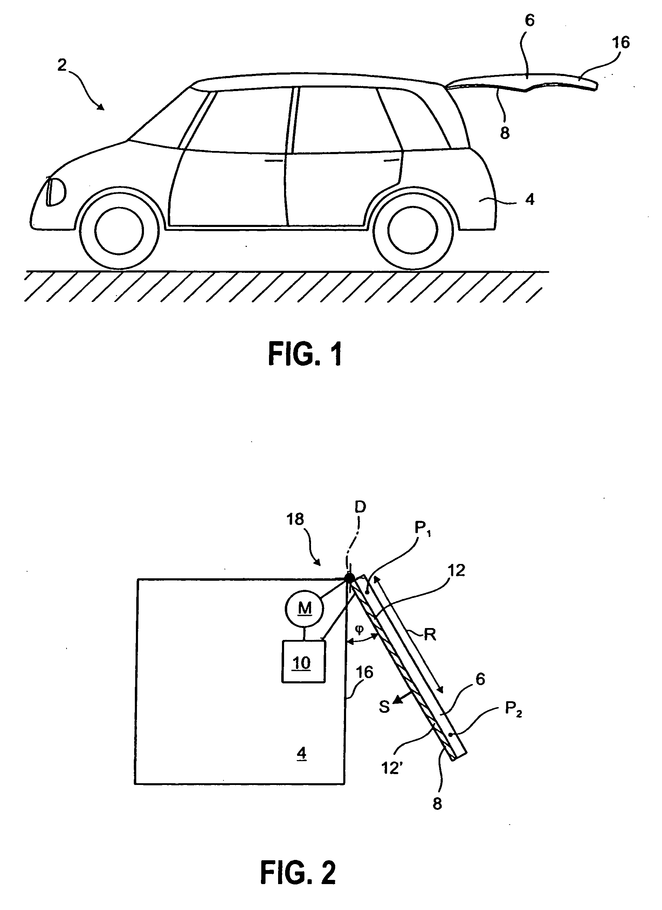

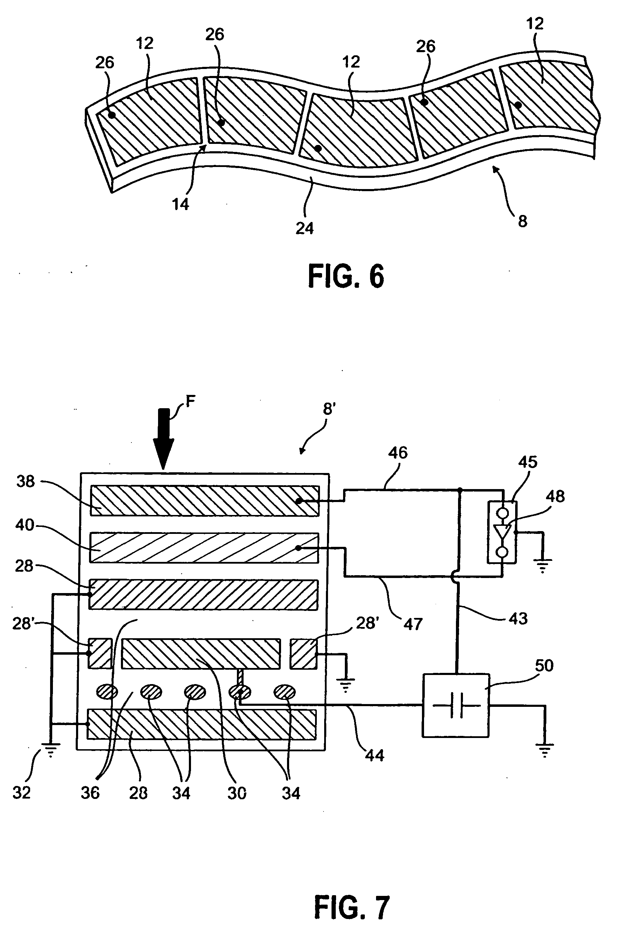

Gleiche Bezugsteile haben in den verschiedenen Figuren die gleiche Bedeutung. Fig. 1 zeigt schematisch eine Seitenansicht eines Kraftfahrzeugs 2 mit einer Karosserie 4 und einer offenen Heckklappe 6. Die Heckklappe 6 stellt ein schwenkbares Stellelement dar, das von einer Steuereinheit angesteuert und durch einen Motor elektrisch angetrieben wird. Beim Schließen der Heckklappe 6 muss sichergestellt werden, dass sich in ihrem Bewegungsbereich, weiterhin auch Gefährdungsbereich genannt, kein Hindernis befindet. Zu diesem Zweck ist entlang der Seitenkanten sowie entlang eines unteren Randes der Heckklappe 6 ein insbesondere als Flachbandkabel ausgebildeter Sensor 8 angebracht. In dem Sensor 8 befinden sich entlang der Radialrichtung der Schwenkbewegung mehrere - hier nicht dargestellte - Segmente einer Elektrode (siehe Fig. 6), die zur Ansteuerung separate Zuleitungen aufweisen. Als Gegenelektrode 16 ist der mit der geerdeten Karosserie 4 des Kraftfahrzeugs 2 verbundene Rahmen der Heckklappe 6 eingesetzt. Die Steuereinheit 10 ist insbesondere in eine Türelektronik oder in die Steuerelektronik des Kraftfahrzeugs 2 integriert. Der Sensor 8, die Steuereinheit und der Motor bilden zusammen eine Einklemmschutzvorrichtung zum Erkennen eines Hindernisses im Wege der schwenkbaren Heckklappe 6.

Die Bewegung der Heckklappe 6 beim Schließen ist in einer stark vereinfachten Darstellung des Kraftfahrzeugs 2 in Fig. 2 gezeigt. Die Heckklappe 6 ist um eine Drehachse D an der Karosserie 4 schwenkbar angeordnet, welche Drehachse D senkrecht zur Zeichnungsebene verläuft und somit als ein Punkt erscheint. Vom Punkt D aus erstreckt sich die Heckklappe 6 in eine Radialrichtung R. Die Heckklappe 6 wird mittels eines elektrischen Motors M angetrieben, der von einer Steuereinheit 10 angesteuert wird. Die Steuereinheit 10 ist hierzu mit dem entlang der Heckklappe 6 angeordneten Sensor 8 verbunden.

Beim Schließen bewegt sich die Heckklappe 6 mit einer mittleren Winkelgeschwindigkeit auf die Karosserie 4 zu, die für alle radialen Bereiche der Heckklappe 6 gilt. Wie aus Figur 2 ersichtlich ist, sind die unterschiedlichen Bereiche der Heckklappe 6 beim selben Öffnungswinkel ϕ abhängig von der Radialentfernung zur Drehachse D unterschiedlich weit von der Karosserie 4 bzw. der gegenüberliegenden Schließkante beabstandet. Wenn z.B. ein Punkt P₁, der radial innenliegend positioniert ist, und ein Punkt P₂, der radial außenliegend positioniert ist, verglichen werden, so weist der Punkt P₁ bei gleichem Öffnungswinkel eine kleinere Entfernung zur Karosserie 4 als der Punkt P₂. Dies führt dazu, dass ein radial innenliegendes Segment 12 des Sensors 8, der entlang der Schließkante der Heckklappe 6 gemäß Fig.1 angeordnet ist, im Punkt P₁ eine höhere Kapazität messen wird als ein radial außenliegendes Segment 12' im Punkt P₂.

Weiterhin ist festzustellen, dass die von den Segmenten 12 und 12' gemessenen Messkapazitäten jeweils einen unterschiedlichen Kapazitätsverlauf über dem Öffnungswinkel ϕ aufweisen. So zeigt der Kapazitätsverlauf des Segments 12, welches auch bei offener Heckklappe 6 näher an der Karosserie 4 ist als das Segment 12' liegt, mit Beginn des Schließvorgangs der Heckklappe 6 mit abnehmendem Öffnungswinkel einen stetigen Anstieg, bis bei geschlossener Heckklappe 6 ein Maximalwert erreicht ist. Der Kapazitätsverlauf des Segments 12' dagegen weist zunächst bei großen Öffnungswinkeln ϕ gar keine oder nur eine sehr geringe Abhängigkeit vom Öffnungswinkel auf, und zeigt erst bei kleinen Öffnungswinkeln ϕ in der Nähe der Gegenelektrode 15 einen steileren Anstieg.

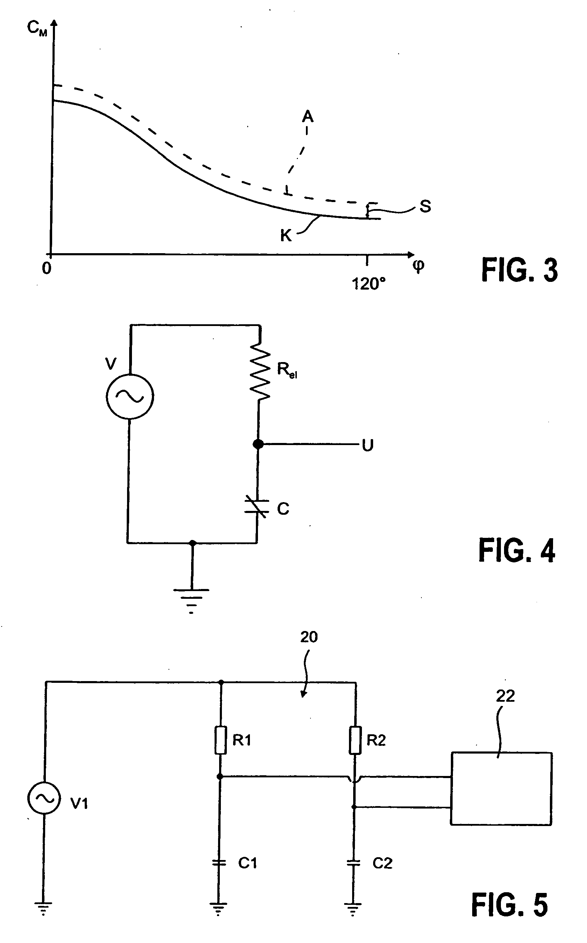

Ein beispielhafter qualitativer Kapazitätsverlauf K für eines der Segmente 12 der Elektrode 14 ist in Fig. 3 veranschaulicht. In dem Diagramm gemäß Fig. 3 ist eine Messkapazität C_{M} des Segments über dem Öffnungswinkel ϕ in einem Winkelbereich von 0° (Heckklappe 6 geschlossen) bis 120° (Heckklappe 6 geöffnet) aufgetragen. Über der Kurve K, die den Kapazitätsverlauf darstellt, ist eine punktierte Linie gezeigt, die dem Verlauf der Kurve K folgt und stets um den gleichen Abstand S über der Kurve V verläuft. Die punktierte Linie gibt einen Abstandswert an und bildet den Verlauf einer Auslöseschwelle A in Abhängigkeit vom Öffnungswinkel ϕ. Wenn die Messkapazität C_{M} für einen bestimmten Winkel ϕ die Auslöseschwelle A überschreitet, interpretiert die Steuereinheit 12 dies als ein Hindernis im Weg der Heckklappe 6. Entsprechend stellt der Bereich zwischen dem Kapazitätsverlauf K und der Auslöseschwelle A einen Toleranzbereich dar, wobei eine Kapazitätsänderung binnen dieses Toleranzbereichs nicht zum Reversieren der Heckklappe 6 führt.

Für jedes Segment 12 der Elektrode 14 ist ein solcher Kapazitätsverlauf K aufgestellt, was zu einer hohen Ortsauflösung bzw. zu einer hohen Detektionssicherheit des Sensors 8 führt. Die Kurve des Kapazitätsverlaufs K wird beispielsweise bei einem Eichvorgang ermittelt und gespeichert und kann als Grundlage zur Bestimmung der Auslöseschwelle A dienen.

Im Betrieb der Heckklappe 6 werden die Messsignale der Segmente 12 einzeln ausgewertet, bzw. die Segmente 12 werden separat angesteuert. Dazu gehört auch, dass die Auslöseschwellen A der Segmente 12 unterschiedlich angepasst bzw. nachgeführt werden. Insbesondere werden die Auslöseschwellen A der einzelnen Segmente 12 unterschiedlich häufig nachgeführt. Bei einem Segment 12, das nah an der Drehachse D ist, z.B. im Bereich des Punkts P₁, ist aufgrund der starken Variation der Messkapazität C_{M} über dem Öffnungswinkel ϕ eine häufige Einstellung einer neuen, dem tatsächlichen Verlauf angepasste Auslöseschwelle A erforderlich. Auf der anderen Seite wird bei einem Segment 12', das radial weit von der Drehachse D entfernt ist, z.B. ein Segment 12, das gem. Fig. 2 den Punkt P₂ umfasst, die Aktualisierung der Auslöseschwelle A im Bereich großer Öffnungswinkel ϕ in etwas längeren Zeitabständen durchgeführt. Im Extremfall können auch, abhängig vom Öffnungswinkel ϕ, einige der Segmente 12 der Elektrode 14 komplett abgeschaltet werden, z.B. die radialinneren Segmenten 12 bei sehr kleinen Öffnungswinkeln ϕ, bei welchen Öffnungswinkeln ϕ aufgrund des hohen Messsignals eine Kapazitätsänderung durch ein Hindernis kaum feststellbar ist, bzw. kein Hindernis mehr in den sehr kleinen Spalt eindringen kann.

Zur Ermittlung der Messkapazität C_{M} der Segmente 12 können verschiedene Messprinzipien angewendet werden. Dies kann beispielsweise über eine Brückenschaltung mittels einer Wechselspannung geschehen, bei der der Spannungsabfall U über der Messkapazität gemessen wird, die in Reihe mit einem ohmschen Widerstand geschaltet ist. Eine solche Brückenschaltung ist schematisch in Fig. 4 dargestellt. Die dort dargestellte elektrische Schaltung umfasst einen Kondensator C, der durch die Messkapazität gebildet wird, eine Wechselspannungsquelle V sowie einen ohmschen Widerstand Rₑₗ. Die Spannung U wird zwischen dem ohmschen Widerstand Rₑₗ und der Messkapazität abgegriffen. Als Maß für die Kapazität kann sowohl die Amplitude der Spannung U als auch ihre Phasenlage verwendet werden. Die derart ermittelte Messkapazität C_{M} wird mit einer entsprechenden Auslöseschwelle A verglichen, um einen möglichen Einklemmfall zu detektieren. Hierbei ist die Auslöseschwelle A entweder als Funktion des Öffnungswinkels ϕ festgelegt, oder sie wird mathematisch als Funktion des Kapazitätsverlaufs K bestimmt, beispielsweise indem man für jeden Öffnungswinkel ϕ zum Wert des Kapazitätsverlaufs V den Wert des Abstands S addiert. Dabei kann auch der Abstandswert S mit dem Öffnungswinkel ϕ variieren. Die Werte der Auslöseschwelle A können außerdem beispielsweise in Form einer Look-Up Tabelle in einem dauerhaften Speicher hinterlegt sein. Vorliegend ist ein Winkelverlauf der Auslöseschwelle für jedes Segment 12 des Sensors 8 bzw. dessen Elektrode vorgegeben. Im Betrieb der Heckklappe 6 wird der Wert der Auslöseschwelle A segmentweise in Abhängigkeit vom Öffnungswinkel ϕ angepasst, wobei der Verlauf der Auslöseschwelle A für jedes Segment 12 unterschiedlich ist und die Anpassung der Auslöseschwelle A segmentbedingt unterschiedlich oft durchgeführt wird.

Bei einem alternativen Messprinzip zur Bestimmung der Messkapazität C_{M} wird die Resonanzfrequenz eines die Messkapazität C_{M} enthaltenden Schwingkreises bestimmt. Somit ändert sich die festgestellte Resonanzfrequenz mit einer Änderung der Messkapazität C_{M}. Die Resonanzfrequenz kann beispielsweise mit einer steuerbaren Wechselspannungsquelle (Voltage Controlled Oszillator) bestimmt werden. Zur Nachführung der Auslöseschwelle wird die Resonanzfrequenz angepasst, die einen Wert für die Auslöseschwelle A darstellt.

Zur Ermittlung der Messkapazität C_{M} über eine Brückenschaltung kann außerdem eine als Referenzkapazität eingesetzte steuerbare Kapazität, insbesondere eine Kapazitätsdiode, vorgesehen sein, wie es aus Fig. 5 ersichtlich wird. Fig. 5 zeigt hierzu eine abgewandelte Auswerteschaltung mittels einer Brückenschaltung. Die Auswerteschaltung umfasst wiederum eine Wechselspannungsquelle V1 zur Erzeugung einer definierten Wechselspannung. Weiter umfasst die gezeigte Auswerteschaltung eine Messbrückenschaltung 20 zur Erfassung der Messkapazitäten. Dabei ist die Messbrückenschaltung 20 aus zwei Brückenzweigen aufgebaut, die jeweils einen ohmschen Widerstand R1 bzw. R2 sowie zwei Kapazitäten C1 bzw. C2 umfassen. Die Kapazität C1 des ersten Brückenzweiges ist dabei gebildet durch die Elektrode 14 und die Gegenelektrode 16 des Sensors 8 und stellt somit die eigentliche Messkapazität dar. Die zweite Kapazität C2 ist als eine Referenzkapazität ausgebildet, wozu eine in Sperrrichtung betriebene, spannungsgesteuerte Kapazitätsdiode eingesetzt ist.

Über einen jeweiligen Spannungsabgriff zwischen den ohmschen Widerständen R1,R2 und den zugeordneten Kapazitäten C1 bzw. C2 ist es einem entsprechend ausgebildeten Auswertemittel 22 möglich, ein der Differenz der Messkapazitäten C1,C2 entsprechendes Differenzsignal zu bilden und hieraus ein Detektionssignal zur Feststellung eines Einklemmfalles abzuleiten.

In Fig. 6 ist der Sensor 8 in einer Aufsicht dargestellt. Man erkennt hierbei die flexible Leiterstruktur 24, die sich leicht entlang einer Kontur des Kraftfahrzeugs 2 führen lässt. Zur Verdeutlichung des Aufbaus ist auf der Oberseite des Sensors 8 das Isolationsmaterial entfernt bzw. nicht eingezeichnet. Aus diesem Grund sind die in Längsrichtung der flexiblen Leiterstruktur 24 unterbrochenen einzelnen Segmente12 der Elektrode 14 deutlich sichtbar. Jedes dieser Segmente 12 weist eine Durchkontaktierung 26 auf, die mit einer separaten Zuleitung verbunden ist. Auf diese Weise ist zur Auswertung des Sensors 8 ein Multiplex-Verfahren anwendbar. Die Segmente 12 werden zeitlich versetzt nacheinander einzeln angesteuert und die hierdurch gebildete Kapazität wird erfasst. Aufgrund der verringerten Fläche der Segmente 12 gegenüber einer durchgängig verlaufenden Leiterbahn ist die Kapazität zwischen den Segmenten 12 und der Gegenelektrode 15 weiter verringert. Dies erlaubt eine weitere Erhöhung der Detektionsempfindlichkeit.

Es sind außerdem Variationen in der Größe der einzelnen Segmente 12 möglich. Hierbei können beispielsweise in einem radialinneren Bereich gegenüber einem radialäußeren Bereich der Heckklappe 6 kleinere und pro Abschnitt insofern mehrere Segmente 12 vorgesehen sein.

Der Aufbau eines beispielhaften, in Form eines Flachbandkabels ausgebildeten Sensors 8', der als Multisensor für eine berührungslose sowie wie für eine taktile Detektion eines Hindernisses ausgebildet ist, wird durch den in Fig. 7 gezeigten Querschnitt ersichtlich. Der Sensor 8' beruht insbesondere auf dem kapazitiven Messprinzip. Der in Fig. 7 dargestellte Sensor 8' umfasst zunächst einen Grundaufbau aus zwei äußeren Grundelektroden 28 sowie eine zwischen den Grundelektroden 28 verlaufende flache Innenelektrode 30. An den Schmalseiten der Innenelektrode 30 sind wiederum zwei Flachleiter oder Leiterbahnen 28' angeordnet, die mit den Grundelektroden 28 jeweils elektrisch kontaktiert sind. Die hierdurch insgesamt gebildete Grundelektrode 28, 28' ist mit einem Grundpotential 32, insbesondere mit dem Erdpotential, verbunden. In Längsrichtung des Flachbandkabels ist die Innenelektrode 30 in mehrere voneinander isolierte Segmente unterteilt. Eines dieser Segmente wird durch den gezeigten Schnitt erfasst. Jedes dieser Segmente verfügt über eine separate Zuleitung 34, über die jeweils die Kapazität zwischen der Innenelektrode 30 und der Grundelektrode 28 gemessen bzw. ausgewertet werden kann. Die separaten Zuleitungen 34 sind dabei innerhalb eines die Grundelektrode 28 und die Innenelektrode 30 trennenden, isolierenden und elastischen Materials 36 angeordnet.

Die Grundeinheit umfassend die Grundelektrode 28,28', die Innenelektrode 30, die Zuleitungen 34 sowie die zwischen den Elektroden angeordnete Schicht aus dem elastischen Material 36 wirkt als ein taktiler kapazitiver Sensor. Zur Bestimmung der Kapazität zwischen den Grundelektroden 28, 28' und der Innenelektrode 30 wird die Grundelektrode 28 auf ein Grundpotential, insbesondere auf Erdpotential, gelegt und die Innenelektrode 30 demgegenüber mit einer Wechselspannung beaufschlagt.

Erfolgt durch einen externen Gegenstand eine Krafteinwirkung auf den Sensor 8' in Richtung des dargestellten Kraftvektors F, so führt dies zu einer Komprimierung der Schichten aus dem elastischen Material 36. Somit verändert sich die Dicke des elastischen Materials 36. Da die Kapazität des die Grundelektrode 28 und die Innenelektrode 30 umfassenden Kondensators von deren Abstand und somit von der Dicke des isolierenden Materials 36 abhängt, führt die gezeigte Krafteinwirkung zu einer Änderung der Kapazität, so dass eine Berührung des Sensors 8' detektierbar wird. Dabei genügt bei dem sich als Flachbandkabel erstreckenden Sensor 8' eine lokal begrenzt wirkende Kraft, um eine detektierbare Kapazitätsänderung hervorzurufen.

Zur Auswertung des Sensors 8' als taktiler Sensor sind die Segmente der Innenelektrode 30 über ihre jeweils separaten Zuleitungen 34 mittels einer Verbindungsleitung 44. an eine Auswerteschaltung 50 angeschlossen, die mit einer Steuereinheit verbunden ist. Somit registriert die Steuereinheit mit Hilfe der Auswerteschaltung 50 eine Änderung der Kapazität zwischen der Grundelektrode 28 und dem jeweiligen Segment der Innenelektrode 30. Ändert sich der Abstand zwischen der oberen und der unteren Grundelektrode 28 und der Innenelektrode 30, so resultiert hieraus eine Kapazitätsänderung, was auf eine Kraft- bzw. Druckeinwirkung an der Stelle des ausgewerteten Segments hinweist. Durch eine serielle Auswertung der Segmente der Innenelektrode 30 kann insbesondere eine Ortsauflösung des taktilen kapazitiven Sensors 8' erreicht werden.

Zusätzlich umfasst der Sensor 8' gemäß Fig. 7 eine wiederum als Flachleiter ausgebildete Elektrode 38, die der oberen Grundelektrode 28 gegenüber angeordnet ist. Zwischen der Elektrode 38 und der oberen Grundelektrode 28 ist eine ebenfalls als Flachleiter ausgebildete Abschirmelektrode 40 angeordnet. Die Elektroden 38 und 40 sind in das isolierende Material 36 eingebettet. Die Baueinheit, bestehend aus oberer Grundelektrode 28, Abschirmelektrode 40 und Elektrode 38 arbeitet als ein berührungsloser, auf dem kapazitiven Messprinzip beruhender Näherungssensor, was im Folgenden beschrieben wird.

Zur Nutzung des Sensors 8' als ein berührungsloser Näherungssensor wird die Elektrode 38 mittels der Signalleitung 46 mit einer Wechselspannung beaufschlagt. Die Wechselspannung wird hierbei durch einen Signalgenerator 45 gegenüber dem Erdpotential erzeugt. Weiter wird mittels der Verbindungsleitung 47 die Abschirmelektrode 40 mit einer Wechselspannung beaufschlagt, die aus der der Elektrode 38 zugeleiteten Wechselspannung abgeleitet ist. Hierfür ist zwischen der Signalleitung 46 und der Verbindungsleitung 47 ein als Operationsverstärker ausgebildetes Schaltmittel 48 eingesetzt. Auf diese Weise wird sichergestellt, dass die Elektrode 38 und die Abschirmelektrode 40 sich ohne zeitliche Verzögerung auf demselben Potential befinden.

Infolge der sich auf gleichem Potential befindlichen Elektrode 38 und Abschirmelektrode 40 bildet sich zwischen der Elektrode 38 und der oberen Grundelektrode 28 keine direkte Kapazität. Diese wird direkt von der Abschirmelektrode 40 und der oberen Grundelektrode 28 gebildet. Stattdessen entsteht zwischen den Kanten der Elektrode 38 und der Masse der Grundelektrode 28 sowie insbesondere einer auf Masse liegenden Karosserie eines Kraftfahrzeugs ein weit in den Raum hinausragendes elektrisches Feld, wodurch ein großer Raum zur Detektion von Hindernissen verfügbar wird. Dabei ist die durch die Elektrode 38 und Masse gebildete Kapazität infolge des Abschirmeffektes durch die Abschirmelektrode 40 deutlich gegenüber einer direkten Kapazität verringert. Zur Messung der Kapazitätsänderung bei Eindringen eines Hindernisses ist die Auswerteschaltung 50 mittels einer Verbindungsleitung 43 mit der Elektrode 38 verbunden. Die Auswerteschaltung bzw. die daran angeschlossene Steuereinheit detektiert hierbei das Verhältnis aus Kapazitätsänderung ΔC zur Kapazität C. Zur Detektion der Kapazität kann entweder eine Brückenschaltung verwendet oder die Ladekonstante beobachtet werden.

Bei dem in Fig. 7 gezeigten Sensor 8' handelt es sich somit um einen Multisensor, der die Funktionen eines taktilen kapazitiven und eines berührungslosen kapazitiven Sensors vereinigt. Der Sensor 8' bietet somit eine hohe Ausfallsicherheit und eignet sich insbesondere zur sicheren Erkennung eines Hindernisses im Schließweg eines Stellelements 6 eines Kraftfahrzeugs 2.

### Bezugszeichenliste

- 2: Kraftfahrzeug
- 4: Karosserie
- 6: Heckklappe
- 8, 8': Sensor
- 10: Steuereinheit
- 12,12': Segment
- 14: Elektrode
- 16: Gegenelektrode
- 18: Einklemmschutzvorrichtung
- 20: Messbrückenschaltung
- 22: Auswertemittel
- 24: flexible Leitstruktur
- 26: Durchkontaktierung
- 28, 28': Grundelektrode
- 30: Innenelektrode
- 32: Grundpotential
- 34: Zuleitung
- 36: Material
- 38: Elektrode
- 40: Abschirmelektrode

- 44: Verbindungsleitung
- 45: Signalgenerator
- 46: Signalleitung
- 47: Verbindungsleitung
- 48: Schaltmittel
- 50: Auswerteschaltung
- A: Auslöseschwelle
- C_{M}, C1, C2: Messkapazität
- C3, C4: Referenzkapazität
- D: Drehachse
- F: Kraft
- K: Kapazitätsverlauf
- M: Motor
- P₁, P₂: Punkte
- R: Radialrichtung
- Rₑₗ, R1, R2: Widerstand
- S: Abstand
- V, V1: Spannungsquelle
- ϕ: Öffnungswinkel

## Patentansprüche

1. Einklemmschutzvorrichtung (18) für ein schwenkbares Stellelement (6) eines Kraftfahrzeugs (2), umfassend einen kapazitiven Sensor (8) zum berührungslosen Erkennen eines Hindernisses im Weg des Stellelements (6) mit einer Elektrode (14) zur Erzeugung eines äußeren elektrischen Feldes gegenüber einer Gegenelektrode (16), wobei die Elektrode (14) sich in eine Radialrichtung (R) der Schwenkbewegung des Stellelements (6) erstreckt, und eine Steuereinheit (10), die dafür eingerichtet ist, eine Änderung einer zwischen der Elektrode (16) und der Gegenelektrode (16) ausgebildeten Messkapazität (C_{M}) als einen Einklemmfall zu interpretieren, wenn die geänderte Messkapazität (C_{M}) eine in Abhängigkeit von einem Öffnungswinkel (ϕ) des schwenkbaren Stellelements (6) vorgegebene Auslöseschwelle (A) überschreitet, und die Auslöseschwelle (A) nachzuführen, wobei die Elektrode (14) entlang der Radialrichtung (R) in mehrere Segmente (12) unterteilt ist, und **dadurch gekennzeichnet, dass** die Steuereinheit (10) dafür eingerichtet ist, die Auslöseschwelle (A) segmentzugeordnet nachzuführen.

2. Einklemmschutzvorrichtung (18) nach Anspruch 1,
**dadurch gekennzeichnet,**
**dass** die Steuereinheit (10) dafür eingerichtet ist, die Auslöseschwelle (A) der Segmente (12) in unterschiedlichen Zeitabständen nachzuführen.

3. Einklemmschutzvorrichtung (18) nach Anspruch 1 oder 2,
**dadurch gekennzeichnet,**
**dass** die Steuereinheit (10) dafür eingerichtet ist, die Auslöseschwelle (A) von radial innenliegenden Segmenten (12) in kürzeren Zeitabständen nachzuführen als die Auslöseschwelle (A) von radial außenliegenden Segmenten (12).

4. Einklemmschutzvorrichtung (18) nach einem der vorhergehenden Ansprüche,
**dadurch gekennzeichnet,**
**dass** die Steuereinheit (10) dafür eingerichtet ist, einzelne Segmente (12) abhängig vom Öffnungswinkel (ϕ) abzuschalten.

5. Einklemmschutzvorrichtung (18) nach einem der vorhergehenden Ansprüche,
**dadurch gekennzeichnet,**
**dass** die Steuereinheit (10) dafür eingerichtet ist, zur Nachführung der Auslöseschwelle (A) eine steuerbare Kapazitätsdiode zu regeln.

6. Einklemmschutzvorrichtung (18) nach einem der vorhergehenden Ansprüche,
**dadurch gekennzeichnet,**
**dass** die Steuereinheit (10) dafür eingerichtet ist, zur Nachführung der Auslöseschwelle (A) einen steuerbaren Vorwiderstand zu regeln.

7. Einklemmschutzvorrichtung (18) nach einem der vorhergehenden Ansprüche,
**dadurch gekennzeichnet,**
**dass** die Steuereinheit (10) dafür eingerichtet ist, zur Nachführung der Auslöseschwelle (A) eine Resonanzfrequenz anzupassen.

8. Einklemmschutzvorrichtung (18) nach einem der vorhergehenden Ansprüche,
**dadurch gekennzeichnet,**
**dass** die Steuereinheit (10) dafür eingerichtet ist, die Auslöseschwelle (A) als einen Abstandswert zu einem Kapazitätsverlauf (K) der Messkapazität über dem Öffnungswinkel (ϕ) vorzugeben.

9. Einklemmschutzvorrichtung (18) nach Anspruch 8,
**dadurch gekennzeichnet,**
**dass** die Steuereinheit (10) dafür eingerichtet ist, den Abstandswert nachzuführen.

10. Einklemmschutzvorrichtung (18) nach einem der vorhergehenden Ansprüche,
**dadurch gekennzeichnet,**
**dass** die Elektrode (14) in einem flexiblen Träger geführt ist.

11. Einklemmschutzvorrichtung (18) nach Anspruch 10,
**dadurch gekennzeichnet,**
**dass** im flexiblen Träger zusätzlich eine Abschirmelektrode (40) zur Richtung des elektrischen Feldes in einen Gefährdungsbereich vorgesehen ist.

12. Einklemmschutzvorrichtung (18) nach Anspruch 11,
**dadurch gekennzeichnet,**
**dass** die Abschirmelektrode (40) in elektrisch kontaktierte Abschirmsegmente unterteilt ist, zwischen denen isoliert separate Zuleitungen angeordnet sind.

13. Einklemmschutzvorrichtung (18) nach einem der vorhergehenden Ansprüche,
**gekennzeichnet durch**
einen zusätzlichen taktilen Sensor (8a).

14. Einklemmschutzvorrichtung (18) nach einem der vorhergehenden Ansprüche,
**dadurch gekennzeichnet,**
**dass** der berührungslose Sensor (8) zugleich als taktiler Sensor (8') ausgestaltet ist.

15. Einklemmschutzvorrichtung (18) nach einem der vorhergehenden Ansprüche,
**dadurch gekennzeichnet,**
**dass** als Gegenelektrode (16) die geerdete Karosserie (4) des Kraftfahrzeugs (2) dient.

16. Auswerteschaltung (50), einer Einklemmschutzvorrichtung (18) gemäß einem der vorhergehenden Ansprüche,
**gekennzeichnet durch**
Messpotenzialausgabemittel zur Ausgabe eines vorgegebenen Messpotenzials an die Elektrode (14), mit Kapazitätserfassungsmitteln zur Erfassung der Messkapazität zwischen der Elektrode (14) und der Gegenelektrode (16) und mit Auswertemitteln zur Ausgabe eines Detektionssignals in Abhängigkeit von einer Änderung der Messkapazität (C_{M}).

17. Auswerteschaltung (50) nach Anspruch 16,
**dadurch gekennzeichnet,**
**dass** die Messpotenzialausgabemittel eine Wechselspannungsquelle umfassen und dass die Kapazitätserfassungsmittel eine Brückenschaltung (20) umfassen, wobei die Messkapazität (C_{M}) in dem Brückenzweig mit einer steuerbaren Kapazitätsdiode parallel geschaltet ist.

## Claims

1. Anti-pinching device (18) for a pivotable actuating element (6) of a motor vehicle (2), comprising a capacitive sensor (8) for contactless detection of an obstacle in the path of the actuating element (6) and an electrode (14) for generating an external electric field opposite of a counter-electrode (16), wherein the electrode (14) extends in a radial direction (R) of the pivoting movement of the actuating element (6), and a control unit (10), which is set up to interpret a change in the measurement capacitance (C_{M}) between the electrode (14) and the counter-electrode (16) as pinching, when the changed measurement capacitance (C_{M}) exceeds a triggering threshold (A), which is defined in relation to an opening angle (ϕ) of the pivotable actuating element (6), and to update the triggering threshold (A), wherein the electrode (14) is separated into a plurality of segments (12) along the radial direction (R) and
**characterized in**
**that** the control unit (10) is set up to update the triggering threshold (A) for each segment respectively.

2. Anti-pinching device (18) according to claim 1,
**characterized in**
the control unit (10) being set up to update the triggering threshold (A) of the segments (12) at different time intervals.

3. Anti-pinching device (18) according to claim 1 or 2,
**characterized in**
the control unit (10) being set up to update the triggering threshold (A) of radially inner segments (12) at shorter time intervals than the triggering threshold (A) of radially outer segments (12).

4. Anti-pinching device (18) according to one of the previous claims,
**characterized in**
the control unit (10) being set up to switch-off individual segments (12) depending on the opening angle (ϕ).

5. Anti-pinching device (18) according to one of the previous claims,
**characterized in**
the control unit (10) being set up to control a controllable capacitance diode for updating the triggering threshold (A).

6. Anti-pinching device (18) according to one of the previous claims,
**characterized in**
the control unit (10) being set up to control a controllable series resistor for updating the triggering threshold (A).

7. Anti-pinching device (18) according to one of the previous claims,
**characterized in**
the control unit (10) being set up to adjust a resonance frequency for updating the triggering threshold (A).

8. Anti-pinching device (18) according to one of the previous claims,
**characterized in**
the control unit (10) being set up to provide the triggering threshold (A) as a distance value to the course (K) of the measurement capacitance as a function of the opening angle (ϕ).

9. Anti-pinching device (18) according to claim 8,
**characterized in**
the control unit (10) being set up to update the triggering threshold (A).

10. Anti-pinching device (18) according to one of the previous claims,
**characterized in**
the electrode (14) being guided in a flexible support.

11. Anti-pinching device (18) according to claim 10,
**characterized in**
an additional shielding electrode (40) being provided in the flexible support to direct the electric field in a pinching zone.

12. Anti-pinching device (18) according to claim 11,
**characterized in**
the shielding electrode (40) being divided in electronically contacted shielding segments, in between which separate isolated feeding lines are arranged.

13. Anti-pinching device (18) according to one of the previous claims,
**characterized in**
having an additional tactile sensor (8').

14. Anti-pinching device (18) according to one of the previous claims,
**characterized in**
**that** the contactless sensor (8) is also a tactile sensor (8').

15. Anti-pinching device (18) according to one of the previous claims,
**characterized in**
the grounded body (4) of the motor vehicle (2) serving as a counter electrode (16).

16. Evaluation circuit (50) of an anti-pinching device (18) according to one of the previous claims,
**characterized in**
having output means for outputting a pre-determined measurement potential to the electrode (14), having sensing means for sensing the measurement capacitance between the electrode (14) and the counter electrode (16) and having evaluation means for providing a detection signal depending on a change of the measurement capacitance (C_{M}).

17. Evaluation circuit (50) according to claim 16,
**characterized in**
the output means comprising an AC voltage source and the sensing means comprising a bridge circuit (20), wherein the measurement capacitance (C_{M}) is connected in parallel to a controllable capacitance diode in the bridge section.

## Revendications

1. Dispositif de protection anti-coincement (18) pour un élément de positionnement pivotant (6) d'un véhicule automobile (2), comprenant un capteur capacitif (8) pour la reconnaissance sans contact d'un obstacle dans le trajet de l'élément de positionnement (6), comprenant une électrode (14) pour générer un champ électrique extérieur par rapport à une contre-électrode (16), ladite électrode (14) s'étendant dans une direction radiale (R) du mouvement pivotant de l'élément de positionnement (6), et une unité de commande (10) qui est conçue pour interpréter une variation d'une capacité de mesure (C_{M}) réalisée entre l'électrode (16) et la contre-électrode (16) comme un cas de coincement, si la capacité de mesure (C_{M}) qui a varié dépasse un seuil de déclenchement (A) prédéterminé en fonction d'un angle d'ouverture (ϕ) de l'élément de positionnement pivotant (6), et pour réajuster le seuil de déclenchement (A),
dans lequel l'électrode (14) est subdivisée en plusieurs segments (12) le long de la direction radiale (R), et
en ce que l'unité de commande (10) est conçue pour réajuster le seuil de déclenchement (A) de façon associée vis-à-vis des segments.

2. Dispositif de protection anti-coincement (18) selon la revendication 1,
**caractérisé en ce que** l'unité de commande (10) est conçue pour réajuster le seuil de déclenchement (A) des segments (12) à des écarts temporels différents.

3. Dispositif de protection anti-coincement (18) selon la revendication 1 ou 2,
**caractérisé en ce que** l'unité de commande (10) est conçu pour réajuster le seuil de déclenchement (A) de segments (12) situés radialement à l'intérieur à des intervalles temporels plus courts que le seuil de déclenchement (A) de segments (12) situés radialement à l'extérieur.

4. Dispositif de protection anti-coincement (18) selon l'une des revendications précédentes,
**caractérisé en ce que** l'unité de commande (10) est conçue pour mettre à l'arrêt des segments individuels (12) en fonction de l'angle d'ouverture (ϕ).

5. Dispositif de protection anti-coincement (18) selon l'une des revendications précédentes,
**caractérisé en ce que** l'unité de commande (10) est conçue, pour réajuster le seuil de déclenchement (A), de manière à réguler une diode capacitive susceptible d'être commandée.

6. Dispositif de protection anti-coincement (18) selon l'une des revendications précédentes,
**caractérisé en ce que** l'unité de commande (10) est conçue, pour réajuster le seuil de déclenchement (A), de manière à réguler une résistance en série susceptible d'être commandée.

7. Dispositif de protection anti-coincement (18) selon l'une des revendications précédentes,
**caractérisé en ce que** l'unité de commande (10) est conçue, pour réajuster le seuil de déclenchement (A), de manière à ajuster une fréquence de résonance.

8. Dispositif de protection anti-coincement (18) selon l'une des revendications précédentes,
**caractérisé en ce que** l'unité de commande (10) est conçue de façon à imposer le seuil de déclenchement (A) sous la forme d'une valeur d'écartement par rapport à une évolution (K) de la capacité de mesure en fonction de l'angle d'ouverture (j).

9. Dispositif de protection anti-coincement (18) selon la revendication 8,
**caractérisé en ce que** l'unité de commande (10) est conçue pour réajuster la valeur d'écartement.

10. Dispositif de protection anti-coincement (18) selon l'une des revendications précédentes,
**caractérisé en ce que** l'électrode (14) est guidée dans un support flexible.

11. Dispositif de protection anti-coincement (18) selon la revendication 10,
**caractérisé en ce qu'**il est prévu en supplément dans le support flexible une électrode-écran (40) pour orienter le champ électrique dans une zone menacée.

12. Dispositif de protection anti-coincement (18) selon la revendication 11,
**caractérisé en ce que** l'électrode-écran (40) est subdivisée en segments d'écran en contact électrique, entre lesquels sont agencées des lignes séparées isolées.

13. Dispositif de protection anti-coincement (18) selon l'une des revendications précédentes,
**caractérisé par** un capteur tactile additionnel (8a).

14. Dispositif de protection anti-coincement (18) selon l'une des revendications précédentes,
**caractérisé en ce que** le capteur sans contact (8) est réalisé simultanément comme capteur tactile (8').

15. Dispositif de protection anti-coincement (18) selon l'une des revendications précédentes,
**caractérisé en ce que** la carrosserie (4) du véhicule automobile (2), mise à la terre, sert de contre-électrode. (16).

16. Circuit d'évaluation (50), d'un dispositif de protection anti-coincement (18) selon l'une des revendications précédentes, **caractérisé par** des moyens pour fournir un potentiel de mesure destiné à fournir un potentiel de mesure prédéterminé à l'électrode (14), comprenant des moyens de détection de capacité pour détecter la capacité de mesure entre l'électrode (14) et la contre-électrode (16), et des moyens d'évaluation pour fournir un signal de détection en fonction d'une variation de la capacité de mesure (C_{M}).

17. Circuit d'évaluation (50) selon la revendication 16,
**caractérisé en ce que** les moyens pour fournir un potentiel de mesure comprennent une source de tension alternative, et **en ce que** les moyens de détection de capacité comprennent un circuit en pont (20), tel que la capacité de mesure (C_{M}) est branchée en parallèle dans la ramification du pont avec une diode capacitive susceptible d'être commandée.
